# EUROPEAN PATENT APPLICATION

(11) **EP 3 920 220 A1**
(43) Date of publication of application: **08.12.2021**
(21) Application number: 21177387.4
(22) Date of filing: 02.06.2021
(51) Int. Cl.: H01L 25/075, F21K 9/20, F21S 2/00, F21V 17/16, F21V 21/00, H01L 33/58

(54) **LIGHTING MODULE AND LIGHTING DEVICE**

(30) Priority: 03.06.2020 CN 202020993657 U
(71) Applicant: Hangzhou Hpwinner Opto Corporation, Hangzhou, Zhejiang 310015 (CN)
(72) Inventor: HUANG,Jianming, Hangzhou City, Zhejiang 310015 (CN); CHEN, Kai, Hangzhou City, Zhejiang 310015 (CN)
(74) Representative: Manitz Finsterwald Patent- und Rechtsanwaltspartnerschaft mbB

(57) **Abstract**

A lighting module and a lighting device. The lighting module includes a base, a light-transmitting plate, at least one light source component and a sealing component; the base includes a bottom plate and a base sidewall; the light-transmitting plate is arranged opposite to the bottom plate at an interval, to form an accommodating space; the at least one light source component is located in the accommodating space, the light source component comprising a lens component, the light-transmitting plate further comprises a light-transmitting plate sidewall, and the light-transmitting plate sidewall and the base sidewall are oppositely arranged at an interval, the sealing component is at least partially located between the light-transmitting plate sidewall and the base sidewall, and is in close contact with the light-transmitting plate sidewall and the base sidewall, respectively. Thus, the lighting module can seal the accommodating groove only by the sealing component, the light-transmitting plate sidewall and the base sidewall.

## Description

### TECHNICAL FIELD

Embodiments of the present disclosure relate to a lighting module and a lighting device.

### BACKGROUND

With the continuous development of economy and the acceleration of urbanization, the market of lighting devices is growing. Generally, the lighting device may include one or more lighting modules, and the lighting modules may include a light emitting element, a heat sink and a lens component. The light emitting element is used for emitting light, the lens component is used for distributing light emitted by the light emitting element, and the heat sink is used for heat dissipation of the light emitting element.

Light emitting diode (LED) is a semiconductor light emitting element. Generally, the light emitting diode includes a semiconductor chip. By applying a current to the semiconductor chip, excess energy can be released through recombination of carriers in the semiconductor to cause photon emission, so that the semiconductor chip can emit light.

### SUMMARY

Embodiments of the present disclosure provide a lighting module and a lighting device. The lighting module includes a base, a light-transmitting plate, at least one light source component and a sealing component; the base includes a bottom plate and a base sidewall, and the base sidewall is arranged along an edge of the bottom plate to form an accommodating groove; the light-transmitting plate is at least partially located in the accommodating groove, and the light-transmitting plate and the bottom plate are oppositely arranged at an interval to form an accommodating space between the bottom plate and the light-transmitting plate. At least one light source component is located in the accommodating space, the light-transmitting plate includes a light-transmitting plate sidewall, and the light-transmitting plate sidewall and the base sidewall are oppositely arranged at an interval. The sealing component is at least partially located between the light-transmitting plate sidewall and the base sidewall, and is in close contact with the light-transmitting plate sidewall and the base sidewall, respectively, so as to seal the accommodating space. The lighting module can avoid the phenomenon that the light emitted from the light source component is shielded by the light-transmitting plate.

At least one embodiment provides a lighting module, including: a base, including a bottom plate and a base sidewall, the base sidewall being arranged along an edge of the bottom plate to form an accommodating groove; a light-transmitting plate, at least partially located in the accommodating groove and arranged opposite to the bottom plate at an interval, to form an accommodating space between the bottom plate and the light-transmitting plate; and at least one light source component, located in the accommodating space, each of the at least one light source component including a lens component configured to distribute light for the each of the at least one light source component, wherein the light-transmitting plate further includes a light-transmitting plate sidewall, and the light-transmitting plate sidewall and the base sidewall are oppositely arranged at an interval, the lighting module further includes a sealing component, which is at least partially located between the light-transmitting plate sidewall and the base sidewall, and is in close contact with the light-transmitting plate sidewall and the base sidewall, respectively, so as to seal the accommodating space.

For example, in the lighting module according to an embodiment of the disclosure, the base sidewall includes: a first sidewall, arranged opposite to an edge of the light source component in a direction parallel to the bottom plate; a second sidewall, arranged opposite to the light-transmitting plate sidewall, the second sidewall is located at a side of the first sidewall away from the bottom plate and a side of the first sidewall away from a center of the bottom plate; and a first platform, respectively connected with the first sidewall and the second sidewall, wherein an orthographic projection of the light-transmitting plate on a plane where the bottom plate is located overlaps with an orthographic projection of the first platform on the plane where the bottom plate is located.

For example, in the lighting module according to an embodiment of the disclosure, the first platform includes a protrusion, the light-transmitting plate is located at a side of the protrusion away from the second sidewall, the protrusion is configured to position the light-transmitting plate.

For example, in the lighting module according to an embodiment of the disclosure, the light-transmitting plate sidewall is in contact with the protrusion.

For example, in the lighting module according to an embodiment of the disclosure, the sealing component includes: a sealing ring, which is at least partially located between the light-transmitting plate sidewall and the second sidewall and in close contact with the light-transmitting plate sidewall and the second sidewall, respectively, and the light-transmitting plate sidewall is configured to apply a force, towards the second sidewall, to the sealing ring, so that the sealing ring is in a compressed state.

For example, in the lighting module according to an embodiment of the disclosure, a cross section of the sealing ring has a shape of circular, and the sealing ring is totally located between the light-transmitting sidewall and the second sidewall.

For example, in the lighting module according to an embodiment of the disclosure, the sealing ring includes a first sealing portion, which is located between the light-transmitting plate sidewall and the second sidewall, the first sealing portion upon being in an uncompressed state includes: a first flat surface, configured to contact the second sidewall; a first arc surface, arranged opposite to the first flat surface, protruding outward and configured to contact with the base sidewall and in a compressed state to form a contact surface.

For example, in the lighting module according to an embodiment of the disclosure, the first sealing portion upon being in an uncompressed state further includes: a first inclined surface, connected with the first arc surface and located at a side of the first arc surface close to the base, wherein the first inclined surface is configured to be spaced from the second sidewall to form a first deformation space.

For example, in the lighting module according to an embodiment of the disclosure, the sealing ring further includes a second sealing portion, the second sealing portion is arranged between the light-transmitting plate and the first platform, and connected with the first sealing portion.

For example, in the lighting module according to an embodiment of the disclosure, a side of the first platform close to the second sealing portion includes a first recessed portion, the first recessed portion forms a second deformation space.

For example, in the lighting module according to an embodiment of the disclosure, base sidewall includes a second recessed portion, which is recessed from a surface of the base sidewall close to the light-transmitting plate and configured to accommodate a part of the sealing component.

For example, in the lighting module according to an embodiment of the disclosure, the base sidewall further includes: a third sidewall, arranged opposite to the light-transmitting plate sidewall with a first interval therebetween, the third sidewall is located at a side of the second sidewall away from the bottom plate; a second platform, connected with the second sidewall and the third sidewall, respectively, wherein the second sidewall is arranged opposite to the light-transmitting plate sidewall with a second interval therebetween, the first interval has a width larger than that of the second interval, the sealing component further includes a sealant, which is at least partially located in the first interval, and is in close contact with the third sidewall and the light-transmitting plate sidewall, respectively.

For example, in the lighting module according to an embodiment of the disclosure, the base sidewall further includes: a third sidewall, arranged opposite to the light-transmitting plate sidewall with a first interval therebetween, the third sidewall is located at a side of the second sidewall away from the bottom plate; a second platform, connected with the second sidewall and the third sidewall, respectively, wherein the sealing component includes a sealant, at least a part of which is located in the first interval, the sealant is in close contact with the third sidewall and the light-transmitting plate sidewall, respectively, so as to seal the accommodating space.

For example, in the lighting module according to an embodiment of the disclosure, the second sidewall is arranged opposite to the light-transmitting plate sidewall with a second interval therebetween, and a width of the first interval is greater than a width of the second interval, the sealant is further located in the second interval

For example, in the lighting module according to an embodiment of the disclosure, the second sidewall is in contact with the light-transmitting plate sidewall.

For example, in the lighting module according to an embodiment of the disclosure, each of the at least one light source component further includes: a circuit board; and at least one light emitting element, located at a side of the circuit board close to the light-transmitting plate, wherein the lens component is located between the at least one light emitting element and the light-transmitting plate, the circuit board is electrically connected with the at least one light emitting element and configured to drive the at least one light emitting element to emit light, the lens component includes at least one lens portion which is arranged in one-to-one correspondence with the at least one light emitting element.

For example, in the lighting module according to an embodiment of the disclosure, the circuit board and the bottom plate are integrated into a whole.

For example, in the lighting module according to an embodiment of the disclosure, the at least one light source component includes a plurality of light source components.

For example, in the lighting module according to an embodiment of the disclosure, a material of the light-transmitting plate includes toughened glass.

At least one embodiment of the disclosure provides a lighting device, including: a plurality of lighting modules each of which is the lighting module according any one of the above items.

For example, the lighting device according to an embodiment of the disclosure further includes: a heat sink, wherein bases of the plurality of lighting modules are fixed on the heat sink to collectively dissipate heat through the heat sink.

### BRIEF DESCRIPTION OF THE DRAWINGS

In order to clearly illustrate the technical solution of the embodiments of the invention, the drawings of the embodiments will be briefly described in the following; it is obvious that the described drawings are only related to some embodiments of the invention and thus are not limitative of the invention.
Fig. 1 is a schematic structural diagram of a lighting module;
Fig. 2 is a schematic structural diagram of a lighting module according to an embodiment of the present disclosure;
Fig. 3 is a schematic cross-sectional view of a sealing ring according to an embodiment of the present disclosure;
Fig. 4 is a schematic structural diagram of another lighting module provided by an embodiment of the present disclosure;
Fig. 5 is a schematic structural diagram of another lighting module provided by an embodiment of the present disclosure;
Fig. 6 is a schematic structural diagram of another lighting module provided by an embodiment of the present disclosure;
Fig. 7 is a schematic structural diagram of another lighting module provided by an embodiment of the present disclosure;
Fig. 8 is a schematic structural diagram of another lighting module provided by an embodiment of the present disclosure; and
Fig. 9 is a schematic structural diagram of a lighting device according to an embodiment of the present disclosure.

### DETAILED DESCRIPTION

In order to make objects, technical details and advantages of the embodiments of the invention apparent, the technical solutions of the embodiment will be described in a clearly and fully understandable way in connection with the drawings related to the embodiments of the invention. It is obvious that the described embodiments are just a part but not all of the embodiments of the invention. Based on the described embodiments herein, those skilled in the art can obtain other embodiment(s), without any inventive work, which should be within the scope of the invention.

Unless otherwise specified, the technical terms or scientific terms used in the disclosure shall have normal meanings understood by those skilled in the art. The words "first", "second" and the like used in the disclosure do not indicate the sequence, the number or the importance but are only used for distinguishing different components. The word "comprise", "include" or the like only indicates that an element or a component before the word contains elements or components listed after the word and equivalents thereof, not excluding other elements or components. The words "connection", "connected" and the like are not limited to physical or mechanical connection but may include electrical connection, either directly or indirectly.

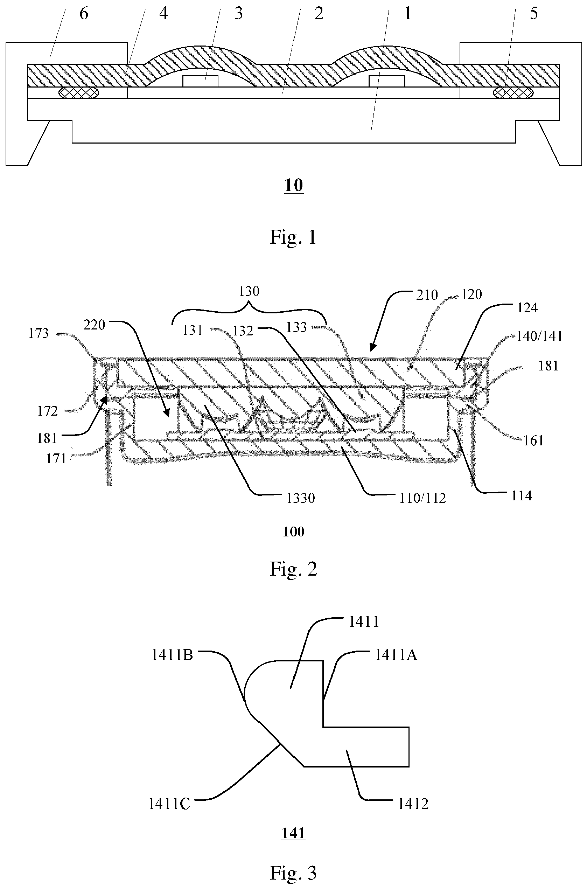

Fig. 1 is a structural diagram of a lighting module. As illustrated by Fig. 1, the lighting module 10 includes a base 1, a circuit board 2, a light emitting element 3, a lens component 4 and a sealing member 5. The base 1 and the lens component 4 are oppositely arranged to form an accommodating space between the base 1 and the lens component 4, and the circuit board 2 and the light emitting element 3 are located in the accommodating space; the sealing member 5 is located at edges of the lens component 4 and the base 1, and located between the lens component 4 and the base 1. In order to seal the accommodation space, the lighting module 10 also needs to be provided with a pressing device 6 at the edge of the lens component 4 to fasten the lens component 4 and the base 1, so that the sealing member 5 is deformed under pressure. Therefore, the deformed sealing member can seal the accommodating space. However, in the lighting module shown in Fig. 1, an edge part of the lens component will be occupied by a screw, a buckle or a frame, which is not conducive to arranging more light emitting elements (e.g., lamp beads) on the circuit board, and it is difficult to improve the brightness and luminous efficiency of the lighting module. In addition, because there is no protective structure on the lens component, the lighting module is easy to be scratched, resulting in the decline of lighting effect. In this regard, a light-transmitting plate can be arranged on a side of the lens component away from the base, so as to protect the lens component. However, the lighting module with a light-transmitting plate needs to fix the light-transmitting plate by a pressing frame or a pressing sheet. In the case where a pressing sheet is adopted, a plurality of pressing sheets are arranged at intervals along the edge of the light-transmitting plate, and the scattered pressing sheets cause uneven pressure on the light-transmitting plate, which leads to poor waterproof effect. In the case where a pressing frame is adopted, the area occupied by the pressing frame is relatively large, which will block the light emitted by the light emitting elements, resulting in a low light emitting angle of the lighting module.

In this regard, embodiments of the present disclosure provide a lighting module and a lighting device. The lighting module includes a base, a light-transmitting plate, at least one light source component and a sealing component; the base includes a bottom plate and a base sidewall, and the base sidewall is arranged along an edge of the bottom plate to form an accommodating groove; the light-transmitting plate is at least partially located in the accommodating groove, and the light-transmitting plate and the bottom plate are oppositely arranged at an interval to form an accommodating space between the bottom plate and the light-transmitting plate. At least one light source component is located in the accommodating space, the light-transmitting plate includes a light-transmitting plate sidewall, and the light-transmitting plate sidewall and the base sidewall are oppositely arranged at an interval. The sealing component is at least partially located between the light-transmitting plate sidewall and the base sidewall, and is in close contact with the light-transmitting plate sidewall and the base sidewall, respectively, so as to seal the accommodating space. The lighting module can seal the accommodation space by the base sidewall, the light-transmitting plate sidewall and the sealing component, without arranging a pressing sheet, a pressing frame, a buckle, or a screw on the edge of the light-transmitting plate. Thus, under the condition that an outer dimension of the lighting module is unchanged (herein, the outer dimension does not include a structure for connecting the lighting module with the outside), the lighting module can increase the area of the accommodation space to set more light emitting elements, thereby improving the utilization rate of the light emitting surface of the lighting module and improving the illumination brightness and luminous efficiency under the condition that the power of the lighting module is unchanged. In addition, because the lighting module does not need to be provided with a pressing plate, a pressing frame, a buckle or a screw on the edge of the lens component, the light emitting surface of the lighting module will not be shielded, and the light emitting angle of the lighting module will not be affected.

Hereinafter, the lighting module and the lighting device provided by the embodiments of the present disclosure will be described in detail with reference to the accompanying drawings.

An embodiment of the present disclosure provides a lighting module. Fig. 2 is a schematic structural diagram of a lighting module according to an embodiment of the present disclosure. As illustrated by Fig. 2, the lighting module 100 includes a base 110, a light-transmitting plate 120, at least one light source component 130 and a sealing component 140. The base 110 includes a bottom plate 112 and a base sidewall 114, and the base sidewall 114 is arranged along an edge of the bottom plate 112 to form an accommodating groove 210. The light-transmitting plate 120 is at least partially located in the accommodating groove 210, and the light-transmitting plate 120 and the bottom plate 112 are oppositely arranged at an interval to form an accommodating space 220 between the bottom plate 112 and the light-transmitting plate 120. At least one light source component 130 is located in the accommodating space 220, and each of the at least one light source component 130 includes a lens component 133, which can distribute light for the light source component 130. The light-transmitting plate 120 further includes a light-transmitting plate sidewall 124, and the light-transmitting plate sidewall 124 and the base sidewall 114 are oppositely arranged at an interval. The sealing component 140 is at least partially located between the light-transmitting plate sidewall 124 and the base sidewall 114, and is in close contact with the light-transmitting plate sidewall 124 and the base sidewall 114, respectively, so as to seal the accommodating space 220.

In the lighting module provided by the embodiment of the present disclosure, a light emitting element can be arranged in the accommodation space and used for emitting light, and sealing the accommodation space can prevent external water and oxygen from corroding the light emitting element, thereby prolonging the service life of the lighting module. Because the sealing component is at least partially located between the light-transmitting plate sidewall and the base sidewall, and is in close contact with the light-transmitting plate sidewall and the base sidewall, respectively, the lighting module can seal the accommodation space only by the sealing component, the light-transmitting plate sidewall and the base sidewall, that is, a lateral sealing mode is provided, without setting additional fixing structures such as a pressing frame, a buckle or a screw on the edge of the light-transmitting plate, and without setting additional sealing structures in the accommodation space. Under the condition that an outer dimension of the lighting module is unchanged, the lighting module can increase the area of the accommodation space to set more light emitting elements (such as light emitting diode lamp beads), thereby improving the utilization rate of the light emitting surface of the lighting module and improving the illumination brightness and luminous efficiency under the condition that the power of the lighting module is unchanged.

On the other hand, because the lighting module does not need to be provided with a pressing sheet, a pressing frame, a buckle or a screw on the edge of the light-transmitting plate, the sealing mode of the lighting module will not shield the light emitting surface of the light-transmitting plate and will not affect the light emitting angle of the lighting module. Therefore, the lighting module also has a larger light emitting angle and a better lighting effect. In addition, because the lighting module is provided with the light-transmitting plate outside the light source component, the light-transmitting plate can be made of a hard material such as toughened glass, which can play a better role in protecting the lighting module, and can also play a role in self-cleaning and oil pollution prevention.

In addition, because the lighting module does not need to be provided with a pressing plate, a pressing frame, a buckle or a screw on the edge of the lens component, and does not need to be provided with a sealing component on the edge of the lens component, the lens component can be free from pressure, thereby avoiding deformation of the lens component caused by pressure. Therefore, the lighting module can keep consistent light distribution effect in the long-term use, and has high stability and durability.

In some examples, as illustrated by Fig. 2, each light source component 130 includes a circuit board 131, at least one light emitting element 132 and a lens component 133; the at least one light emitting element 132 is located at a side of the circuit board 131 close to the light-transmitting plate 120. The lens component 133 is located between the at least one light emitting element 132 and the light-transmitting plate 120. The circuit board 131 is electrically connected with the at least one light emitting element 132 and configured to drive the at least one light emitting element 132 to emit light. The lens component 133 includes at least one lens portion 1330 which is arranged in one-to-one correspondence with the at least one light emitting element 132 to distribute light for the at least one light emitting element 132 respectively, thereby improving the light emitting effect of the lighting module.

For example, as illustrated by Fig. 2, the lighting module 100 includes one light source component 130. However, embodiments of the present disclosure include but are not limited thereto, and the lighting module may include a plurality of light source components arranged side by side; and the number of light source components can be designed according to actual requirements.

For example, as illustrated by Fig. 2, each light source component 130 includes a plurality of light emitting elements 132. However, the embodiments of the present disclosure include but are not limited thereto, and each light source component may only include one light emitting element 132. Similarly, the number of light emitting elements can be designed according to actual requirements.

For example, the light emitting element can be a light emitting diode (LED). Therefore, the lighting module has the advantages of high luminous efficiency, energy saving and environmental protection.

In some examples, the circuit board and the bottom plate may be integrated into a whole. That is to say, a circuit structure on the circuit board can be directly manufactured on the bottom plate, thereby reducing the thickness of the lighting module.

In some examples, the material of the light-transmitting plate may be a hard transparent material, such as toughened glass. Therefore, the light-transmitting plate has high light transmittance, and meanwhile can play a role in protecting the light source component below, thus avoiding the lens component from being scratched. Moreover, toughened glass can also prevent dust and oil pollution. Of course, the material of the light-transmitting plate is not limited to toughened glass, and other hard transparent materials can also be used as the material of the light-transmitting plate.

In some examples, as illustrated by Fig. 2, the base sidewall 114 includes a first sidewall 171, a second sidewall 172 and a first platform 161; the first sidewall 171 is arranged opposite to an edge of the light source component 130 in a direction parallel to the bottom plate 112; the second sidewall 172 is arranged opposite to the light-transmitting plate sidewall 124, and the second sidewall 172 is located at a side of the first sidewall 171 away from the center of the bottom plate 112. The first platform 161 is connected with the first sidewall 171 and the second sidewall 172 respectively, and an orthographic projection of the light-transmitting plate 120 on a plane where the bottom plate 112 is located is overlaps with an orthographic projection of the first platform 161 on the plane where the bottom plate 110 is located. Therefore, the light-transmitting plate 120 can be placed on the first platform 161, thereby forming the accommodation space 220 with the bottom plate 112.

In some examples, as illustrated by Fig. 2, the sealing component 140 may include a sealing ring 141, which is at least partially located between the light-transmitting plate sidewall 124 and the second sidewall 172 and in close contact with the light-transmitting plate sidewall 124 and the second sidewall 172, respectively, and the light-transmitting plate sidewall 124 is configured to apply a force, towards the second sidewall 172, to the sealing ring 141 so that the sealing ring 141 is in a compressed state. Therefore, the sealing ring in a compressed state can seal the accommodating space. In addition, compared with the situation that the sealing ring is compressed by the force perpendicular to the bottom plate, in the case where the sealing ring is compressed by the force perpendicular to the light-transmitting plate sidewall, a size of the sealing ring in the direction perpendicular to the light-transmitting plate sidewall is smaller, so that the utilization rate of the light emitting surface of the lighting module can be further improved, and the illumination brightness and luminous efficiency can be improved under the condition that the power of the lighting module is unchanged.

Fig. 3 is a schematic cross-sectional diagram of a sealing ring according to an embodiment of the present disclosure; Fig. 3 is an enlarged schematic diagram of the sealing ring shown in Fig. 2. As illustrated by Figs. 2 and 3, the sealing ring 141 includes a first sealing portion 1411, which is located between the light-transmitting plate sidewall 124 and the second sidewall 172. Upon the sealing ring 141 being in an uncompressed state, the first sealing portion 1411 includes a first flat surface 1411A and a first arc surface 1411B. The first flat surface 1411A is configured to contact the light-transmitting plate sidewall 124. The first arc surface 1411B is arranged opposite to the first flat surface 1411A, and protrudes outwards to be in close contact with the second sidewall 172 and in a compressed state to from a contact surface. It should be noted that the above-mentioned first flat surface refers to a flat surface at least in the direction perpendicular to the bottom plate. In the case where the shape of the orthographic projection of the sealing ring on the bottom plate is a rounded polygonal ring (for example, a rounded rectangular ring), the contact surface between the first sealing portion and the second sidewall at the rounded corner can be changed correspondingly according to the shape of the second sidewall. For example, in the case where the second sidewall at the rounded corner is curved, the surface of the first sealing portion contacting the second sidewall may also be a arc surface.

In the lighting module according to the present example, the first flat surface is used to contact with the light-transmitting plate sidewall, so that the sealing ring can have better contact with the light-transmitting plate sidewall, and the sealing ring can be stably sleeved on the light-transmitting plate sidewall to avoid the sealing ring from twisting. The first arc surface is arranged opposite to the first flat surface and used for contacting with the base sidewall, and the first arc surface has a certain guiding function, so that the sealing ring can be extruded onto the base sidewall more smoothly.

In some examples, as illustrated by Figs. 2 and 3, upon the sealing ring being in an uncompressed state, the first sealing portion 1411 further includes a first inclined surface 1411C connected with the first arc surface 1411B and located at a side of the first arc surface 1411B close to the base 112, and the first inclined surface 1411C and the second sidewall 172 are oppositely arranged at an interval to form a first deformation space. Therefore, the first deformation space can be used to accommodate the deformation of the compressed sealing ring, so that the sealing ring can be prevented from jumping out due to the compression deformation. On the other hand, a plane where the first inclined surface is located and a plane where the first flat surface is located form an acute angle close to the first sidewall, which has a certain guiding effect, thus facilitating installation.

In some examples, as illustrated by Figs. 2 and 3, the sealing ring 141 further includes a second sealing portion 1412, which is arranged between the light-transmitting plate 120 and the first platform 161 and connected with the first sealing portion 1411. The first sealing portion 1411 and the second sealing portion 1412 are of an integrated structure, and the sealing ring 141 can be better wrapped on the light-transmitting plate 120 by the second sealing portion 1412, and the sealing ring 1411 can be prevented from twisting upon the light-transmitting plate 120 and the sealing ring 141 are pressed down to the base 110. Of course, the embodiment of the present disclosure includes but is not limited thereto, and the sealing ring may only include the first sealing portion described above, and the cross-sectional shape of the first sealing portion is not limited to the shape shown in Fig. 3, but may also be a round shape, a square shape, etc.

In some examples, as illustrated by Fig. 2, the side of the first platform 161 close to the second sealing portion 1412 includes a first recessed portion 181, and the first recessed portion 181 forms a second deformation space. Therefore, the second deformation space can reserve space for the deformation of the sealing ring and prevent the sealing ring from jumping out due to compression deformation.

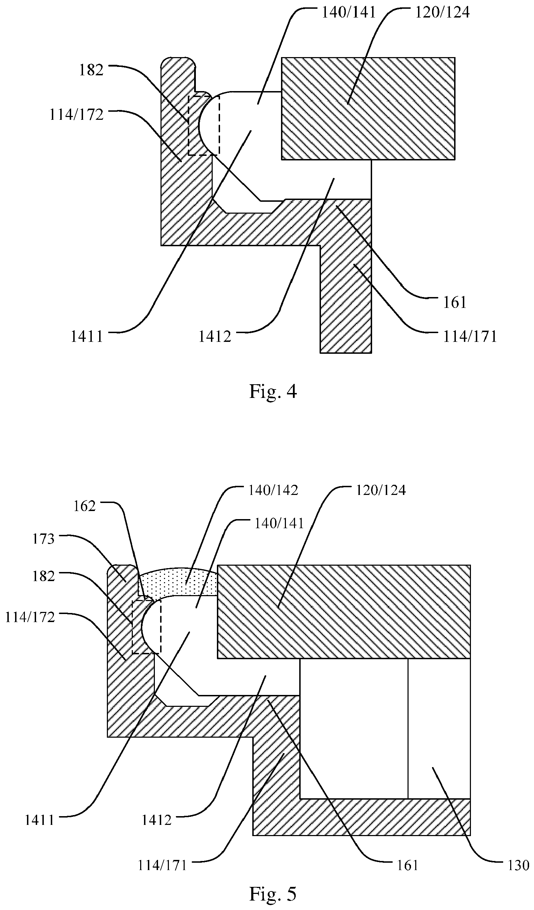

Fig. 4 is a schematic structural diagram of another lighting module according to an embodiment of the present disclosure. As illustrated by Fig. 4, the base sidewall 114 includes a second recessed portion 182, which is recessed from the surface of the base sidewall 114 close to the light-transmitting plate 120 and can accommodate a part of the sealing component 140. Therefore, the second recessed portion 182 can limit the sealing component 140 and enhance the sealing and waterproof performance.

For example, as illustrated by Fig. 4, in the case where the base sidewall 114 includes a first sidewall 171 and a second sidewall 172, and the sealing component 140 is a sealing ring 141, the second sidewall 172 includes the above-mentioned second recessed portion 182, which is recessed from the surface of the base sidewall 114 close to the light-transmitting plate 120 and can accommodate a part of the sealing ring 141.

Fig. 5 is a schematic structural diagram of another lighting module according to an embodiment of the present disclosure. As illustrated by Fig. 5, the base sidewall 114 further includes a third sidewall 173 and a second platform 162; the third sidewall 173 is arranged opposite to the light-transmitting plate sidewall 124 with a first interval therebetween, and the third sidewall 173 is located at a side of the second sidewall 172 away from the bottom plate 112; the second platform 162 is connected with the second sidewall 172 and the third sidewall 173, respectively. The second sidewall 172 is arranged opposite to the light-transmitting plate sidewall 124 with a second interval, and the width of the first interval is greater than that of the second interval. In this case, as illustrated by Fig. 5, the sealing component 140 further includes a sealant 142, which is at least partially located in the first interval, and the sealant 142 is in close contact with the third sidewall 173 and the light-transmitting plate sidewall 124, respectively. That is to say, the sealing component 140 can include a sealing ring 141 and a sealant 142 at the same time, and the sealing ring 141 is at least partially located between the light-transmitting plate sidewall 124 and the second sidewall 172 and in close contact with the light-transmitting plate sidewall 124 and the second sidewall 172, respectively; and the sealant 142 is located at a side of the sealing ring 141 away from the first platform 161, and at least a part of the sealant 142 is located in the first interval, and is in close contact with the third sidewall 173 and the light-transmitting plate sidewall 124 respectively, thereby further enhancing the sealing and waterproof performance of the lighting module. In addition, because the width of the first interval is set larger than that of the second interval, it is more convenient to carry out the processes such as a process of applying the sealant.

In some examples, as illustrated by Fig. 5, the first sidewall 171 and an edge of the light source component 130 have a third interval, and the width of the third interval is larger than that of the first interval. Therefore, the light source component 130 has a certain distance from the base sidewall 114, which can prevent the base sidewall 114 from shielding the light emitted by the light source component 130, so that the lighting module has a larger light emitting angle. Of course, the embodiments of the present disclosure include but are not limited thereto, and the width of the third interval can also be smaller than or equal to the width of the first interval, so that more light source components or larger light source components can be arranged in the accommodation space, thereby improving the illumination brightness and luminous efficiency.

It should be noted that, Fig. 4 shows the case where the sealing component only includes a sealing ring; Fig. 5 shows the case where the sealing component includes both a sealing ring and a sealant, however, the embodiment of the present disclosure includes but is not limited thereto, and the sealing component may only include the sealant.

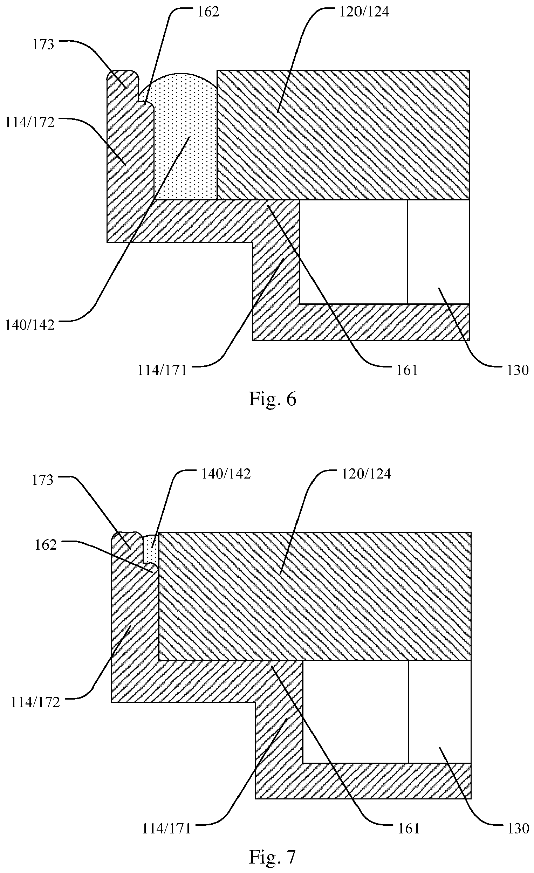

Fig. 6 is a schematic structural diagram of another lighting module provided by an embodiment of the present disclosure. As illustrated by Fig. 6, the base sidewall 114 includes a third sidewall 173 and a second platform 162; the third sidewall 173 is arranged opposite to the light-transmitting plate sidewall 124 with a first interval, and the third sidewall 173 is located at a side of the second sidewall 172 away from the bottom plate 112; the second platform 162 is connected to the second sidewall 172 and the third sidewall 173, respectively. The sealing component 140 may only include a sealant 142, which is at least partially located in the first interval, and the sealant 142 is in close contact with the third sidewall 173 and the light-transmitting plate sidewall 124, respectively, so as to seal the accommodating space 210.

In some examples, as illustrated by Fig. 6, the second sidewall 172 and the light-transmitting plate sidewall 124 are oppositely arranged with a second interval therebetween, the width of the second interval is smaller than that of the first interval, and the sealant 142 is also located in the second interval.

In some examples, as illustrated by Fig. 6, the first sidewall 171 and the edge of the light source component 130 have a third interval therebetween, and the width of the third interval is larger than that of the first interval. Similarly, the light source component 130 has a certain distance from the base sidewall 114, which can prevent the base sidewall 114 from shielding the light emitted by the light source component 130, so that the lighting module has a larger lighting angle. Of course, the embodiments of the present disclosure include but are not limited thereto, and the width of the third interval can also be smaller than or equal to the width of the first interval, so that more light source components or larger light source components are arranged in the accommodation space, thereby improving the illumination brightness and luminous efficiency.

Fig. 7 is a schematic structural diagram of another lighting module provided by an embodiment of the present disclosure. As illustrated by Fig. 7, the second sidewall 172 is in contact with the light-transmitting plate sidewall 124, that is, the second interval is zero. As illustrated by Fig. 7, the sealant 142 is located in the first interval, and the sealant 142 is in close contact with the third sidewall 173 and the light-transmitting plate sidewall 124, respectively, to seal the accommodating space 210. Therefore, in the case where the sealant is used for sealing, the second sidewall and the light-transmitting plate sidewall are in contact with each other, so that the second sidewall and the light-transmitting plate sidewall can have certain sealing and waterproof effects.

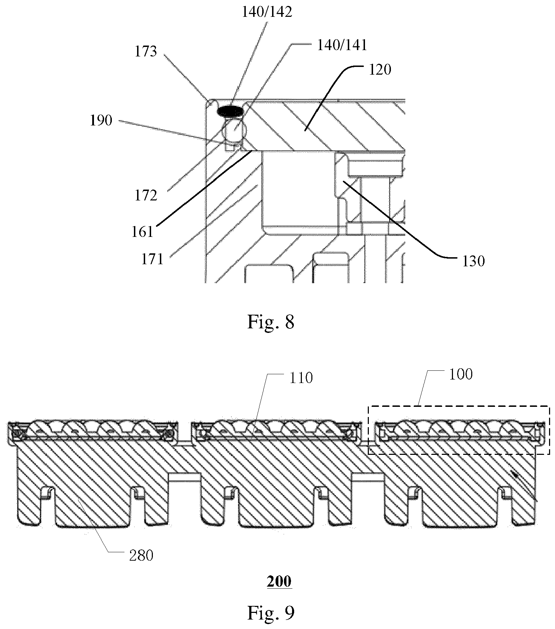

Fig. 8 is a schematic structural diagram of another lighting module provided by an embodiment of the present disclosure. As illustrated by Fig. 8, the first platform 161 includes a protrusion 190, and the light-transmitting plate 120 is located at a side of the protrusion 190 away from the second sidewall 172, that is, the light-transmitting plate 120 is located at an inner side of the protrusion 190. In this case, the protrusion 190 can position or limit the light-transmitting plate 120. On the one hand, the protrusion is beneficial to the installation of the light-transmitting plate; on the other hand, the protrusion can prevent the light-transmitting plate from sliding.

In some examples, as illustrated by Fig. 8, the light-transmitting plate sidewall 124 is in contact with the protrusion 190. Therefore, the protrusion 190 can also play a sealing role to further improve the sealing performance and waterproof performance of the lighting module.

In some examples, in the lighting module shown in Fig. 8, the light-transmitting plate 120 may be placed on the first platform, so the sealing ring 141 may only include the first sealing portion described above, and not include the second sealing portion located between the light-transmitting plate and the first platform. For example, as illustrated by Fig. 8, the cross section of the sealing ring 141 is circular, and the sealing ring 141 is totally located between the light-transmitting plate sidewall 124 and the second sidewall 172.

An embodiment of the present disclosure also provides a lighting device. Fig. 9 is a structural schematic diagram of a lighting device according to an embodiment of the present disclosure. As illustrated by Fig. 9, the lighting device 200 includes the lighting module 100 as described above. Therefore, the lighting device also has the beneficial effects corresponding to the beneficial effects of the lighting module, and the repeated portions are omitted herein. For details, please refer to the related description of the lighting module.

In some examples, the lighting device can be a street lamp, a stadium lamp, an airport lamp and the like.

In some examples, as illustrated by Fig. 9, the lighting device 200 includes a plurality of lighting modules 100 and a heat sink 280; bases 110 of the plurality of lighting modules 100 are fixed on the heat sink 280 to collectively dissipate heat through the heat sink 280.

The following points should be noted:
(1) Those not involved in the embodiment of the present disclosure refer to the conventional design.
(2) For clarity, the thickness of layers or areas in the accompanying drawings of the embodiments of the present disclosure is enlarged. It should be understood that when an element such as a layer, a film, an area or a circuit board is referred to be disposed "on" or "beneath" another element, the element may be "directly" disposed "on" or "beneath" another element, or an intermediate element may be provided.
(3) The embodiments of the present invention and the characteristics in the embodiments may be mutually combined without conflict.

The above is only the specific embodiment of the disclosure, but the protection scope of this disclosure is not limited to this. Any those skilled in the art can easily think of changes or substitutions within the technical scope disclosed in this disclosure, which should be covered within the protection scope of this disclosure. Therefore, the protection scope of this disclosure shall be subject to the protection scope of the claims.

## Claims

1. A lighting module, comprising:
a base, comprising a bottom plate and a base sidewall, the base sidewall being arranged along an edge of the bottom plate to form an accommodating groove;
a light-transmitting plate, at least partially located in the accommodating groove and arranged opposite to the bottom plate at an interval, to form an accommodating space between the bottom plate and the light-transmitting plate; and
at least one light source component, located in the accommodating space, each of the at least one light source component comprising a lens component configured to distribute light for the each of the at least one light source component,
wherein the light-transmitting plate further comprises a light-transmitting plate sidewall, and the light-transmitting plate sidewall and the base sidewall are oppositely arranged at an interval, the lighting module further comprises a sealing component, which is at least partially located between the light-transmitting plate sidewall and the base sidewall, and is in close contact with the light-transmitting plate sidewall and the base sidewall, respectively, so as to seal the accommodating space.

2. The lighting module according to claim 1, wherein the base sidewall comprises:
a first sidewall, arranged opposite to an edge of the light source component in a direction parallel to the bottom plate;
a second sidewall, arranged opposite to the light-transmitting plate sidewall, the second sidewall is located at a side of the first sidewall away from the bottom plate and a side of the first sidewall away from a center of the bottom plate; and
a first platform, respectively connected with the first sidewall and the second sidewall,
wherein an orthographic projection of the light-transmitting plate on a plane where the bottom plate is located overlaps with an orthographic projection of the first platform on the plane where the bottom plate is located.

3. The lighting module according to claim 2, wherein the first platform comprises a protrusion, the light-transmitting plate is located at a side of the protrusion away from the second sidewall, the protrusion is configured to position the light-transmitting plate.

4. The lighting module according to claim 3, wherein the light-transmitting plate sidewall is in contact with the protrusion.

5. The lighting module according to any one of claims 2-4, wherein the sealing component comprises:
a sealing ring, which is at least partially located between the light-transmitting plate sidewall and the second sidewall and in close contact with the light-transmitting plate sidewall and the second sidewall, respectively, and the light-transmitting plate sidewall is configured to apply a force, towards the second sidewall, to the sealing ring, so that the sealing ring is in a compressed state.

6. The lighting module according to claim 5, wherein the sealing ring comprises a first sealing portion, which is located between the light-transmitting plate sidewall and the second sidewall, the first sealing portion upon being in an uncompressed state comprises:
a first flat surface, configured to contact the second sidewall;
a first arc surface, arranged opposite to the first flat surface, protruding outward and configured to contact with the base sidewall and in a compressed state to form a contact surface; and
a first inclined surface, connected with the first arc surface and located at a side of the first arc surface close to the base,
wherein the first inclined surface is configured to be spaced from the second sidewall to form a first deformation space.

7. The lighting module according to claim 6, wherein the sealing ring further comprises a second sealing portion, the second sealing portion is arranged between the light-transmitting plate and the first platform, and connected with the first sealing portion.

8. The lighting module according to claim 7, wherein a side of the first platform close to the second sealing portion comprises a first recessed portion, the first recessed portion forms a second deformation space.

9. The lighting module according to any one of claims 1-4, wherein base sidewall comprises a second recessed portion, which is recessed from a surface of the base sidewall close to the light-transmitting plate and configured to accommodate a part of the sealing component.

10. The lighting module according to any one of claims 2-4, wherein the base sidewall further comprises:
a third sidewall, arranged opposite to the light-transmitting plate sidewall with a first interval therebetween, the third sidewall is located at a side of the second sidewall away from the bottom plate;
a second platform, connected with the second sidewall and the third sidewall, respectively,
wherein the second sidewall is arranged opposite to the light-transmitting plate sidewall with a second interval therebetween, the first interval has a width larger than that of the second interval,
the sealing component comprises a sealing ring, which is at least partially located between the light-transmitting sidewall and the second sidewall, and in close contact with the light-transmitting plate sidewall and the second sidewall, respectively, the light-transmitting plate sidewall is configured to apply a force, towards the second sidewall, to the sealing ring, so that the sealing ring is in a compressed state; and a sealant, which is located at a side of the sealing ring away from the first platform, the sealant is at least partially located in the first interval, and is in close contact with the third sidewall and the light-transmitting plate sidewall, respectively.

11. The lighting module according to any one of claims 2-4, wherein the base sidewall further comprises:
a third sidewall, arranged opposite to the light-transmitting plate sidewall with a first interval therebetween, the third sidewall is located at a side of the second sidewall away from the bottom plate;
a second platform, connected with the second sidewall and the third sidewall, respectively,
wherein the sealing component comprises a sealant, at least a part of which is located in the first interval, the sealant is in close contact with the third sidewall and the light-transmitting plate sidewall, respectively, so as to seal the accommodating space.

12. The lighting module according to claim 11, wherein the second sidewall is arranged opposite to the light-transmitting plate sidewall with a second interval therebetween, and a width of the first interval is greater than a width of the second interval, the sealant is further located in the second interval,
or, the second sidewall is in contact with the light-transmitting plate sidewall.

13. The lighting module according to any one of claims 1-12, wherein each of the at least one light source component further comprises:
a circuit board; and
at least one light emitting element, located at a side of the circuit board close to the light-transmitting plate,
wherein the lens component is located between the at least one light emitting element and the light-transmitting plate, the circuit board is electrically connected with the at least one light emitting element and configured to drive the at least one light emitting element to emit light, the lens component comprises at least one lens portion which is arranged in one-to-one correspondence with the at least one light emitting element,
preferably, the circuit board and the bottom plate are integrated into a whole.

14. The lighting module according to any one of claims 1-13, wherein a material of the light-transmitting plate comprises toughened glass.

15. A lighting device, comprising:
a plurality of lighting modules each of which is the lighting module according any one of claims 1-14; and
a heat sink,
wherein bases of the plurality of lighting modules are fixed on the heat sink to collectively dissipate heat through the heat sink.
